# EUROPEAN PATENT SPECIFICATION

(11) **EP 2 951 850 B1**
(45) Date of publication and mention of the grant of the patent: **13.10.2021**
(21) Application number: 14701610.9
(22) Date of filing: 24.01.2014
(51) Int. Cl.: H01J 37/32, B05D 3/06

(54) **APPARATUS AND METHODS FOR DEFINING A PLASMA**
VORRICHTUNG UND VERFAHREN ZUR DEFINITION EINES PLASMA
DISPOSITIF ET MÉTHODE POUR DEFINIR UN PLASMA

(30) Priority: 01.02.2013 GB 201301839
(43) Date of publication of application: 09.12.2015
(73) Proprietor: Camvac Limited, Thetford Norfolk IP24 3QY (GB)
(72) Inventor: ANTHONY, David, Thetford Norfolk IP24 3QY (GB); TOPPING, John, Abingdon Oxfordshire OX14 4BS (GB)
(74) Representative: Latham, Stuart Alexander
(86) International application number: PCT/GB2014/050186
(87) International publication number: WO 2014/118513

(56) References cited:
- EP-A1- 2 168 691
- WO-A1-00/35604
- WO-A1-93/06258
- MENG CHEN ET AL: "Plasma polymerization of styrene with controlled particle energy", JOURNAL OF POLYMER SCIENCE PART A: POLYMER CHEMISTRY, vol. 36, no. 8, 1 June 1998 (1998-06-01), pages 1265-1270, XP055104675, ISSN: 0887-624X, DOI: 10.1002/(SICI)1099-0518(199806)36:8<1265:: AID-POLA9>3.3.CO;2-7
- None

## Description

### Background

Films having enhanced barrier properties for oxygen or other gases or odours or water vapour are produced by depositing alternate layers of cured polymer and metal or compounds onto a web substrate using processes such as vacuum deposition. These films are useful for packaging of oxygen or moisture sensitive foodstuffs, encapsulation of gas or moisture sensitive components, and a variety of other functional applications requiring barrier properties.

It is known to deposit layers of cured polymer onto a web substrate using vacuum deposition. However, known processes of vacuum condensation and curing of polymer precursors have a number of drawbacks/risks, associated with impurities in the commercial grades of raw materials used, particularly for the substrate, or inherent in the process itself. The risks associated with impurities, such as the inhibition of polymerisation of the condensate by oxygen adsorbed in the substrate and associated adhesion problems, or uneven wetting due to contaminants or low molecular weight species on the substrate surface, can often be alleviated by plasma treatment of the substrate before coating e.g. with a gas plasma. However, other problems inherent in the process are more difficult to overcome. For example:
- It is known that the condensate can re-evaporate before reaching the curing zone. This vapour can then potentially contaminate the pumps, or become entrained with the moving web, re-condense on the surface of the cured coating as an uncured, and therefore weak surface layer (giving poor adhesion of any subsequent coatings applied to the material).
- It is known that as the curing of the condensate only takes place within the zone of irradiation, at high line speeds (essential for an economically viable process), 100% polymerisation is difficult to achieve, particularly at the surface adjacent to the substrate and thus furthest from the radiation source. Increasing the radiation flux to increase curing can result in over-curing and embrittlement of the top surface of the coating closest to the radiation source, whilst still leaving the bottom surface under-cured and with poor adhesion. It is difficult therefore to achieve the homogeneity of curing through the thickness of the coating desirable for good mechanical strength, adhesion or barrier.
- It is known that if the precursor vapour or atomised liquid is passed through the radiation flux prior to delivery on the substrate, it can partially polymerise, giving rise to a non-homogeneous and mechanically weak coating with poor adhesion. This phenomenon is known in the art as "snowing".
- It is known that if the coating is cured using a charged radiation flux, such as a high energy electron beam, the resultant coated web can "block" (i.e. stick to itself) when it is wound up into a roll, and then later tear when it is unwound. The risk of damage on unwinding is further accentuated by poor homogeneity through the coating.
- It is known that the surfaces of cured films produced by the processes already known in the art have to be further treated (e.g. with a plasma) before they can be further coated.

Various radiation sources have been used to cure polymer precursors once condensed on a substrate, for example ultraviolet, visible or infra-red or, particularly, electron beam radiation. Atmospheric plasmas are also used, generally for secondary curing (i.e. as an adjunct to electron beam, to complete the cure). These have high energy levels, and high ionisation fractions, and the prior art teaches that this high level of ionisation is essential for polymerisation.

It is also known to pass a monomer vapour through a glow discharge electrode to create a glow discharge conjugated monomer plasma and then direct it towards a substrate using a driving voltage in the glow discharge which is positive with respect to the local conditions at the substrate. The monomer containing these free radicals then condenses on the substrate, where the free radicals initiate curing. However, such systems may not be suitable for running at high line speeds.

It is also known to treat or process web substrates prior to the application of further materials to aid in adhesion. This may be achieved by exposing the surface of the web substrate to radiation such as plasma. While such steps may be beneficial, they generally increase the amount of space required to implement the process due to the additional pieces of apparatus that are required to perform the steps.

EP 2 168 691 A1 describes a process for coating a substrate comprising condensing a radiation curable material on a substrate and curing it using an electron flux with energy between 6.5eV and 300eV.

MENG CHEN ET AL: "Plasma Polymerization of Styrene with Controlled Particle Energy" JOURNAL OF POLYMER SCIENCE PART A: POLYMER CHEMISTRY, vol. 36, no. 8, 1 June 1998 (1998-06-01), pages 1265-1270, XP055104675, ISSN: 0887-624X, describes a type of reactor for plasma polymerization which was developed in order to achieve an effective control of styrene polymerization process.

### Summary

According to a first aspect of the present invention there is provided apparatus according to claim 1.

The ion flux described herein may comprise cations and in some cases other positively charged or non-charged particles and species, but the positively charged ions are the primary curing or processing initiator. The present inventors have discovered that an ion flux having an energy level between 3.6eV and 250eV can unexpectedly perform useful processing and curing operations.

The ion flux may be biased or extracted from the plasma with a driving voltage that is positive relative to the substrate and/or support. The driving voltage may be provided on the opposite side of the plasma with respect to the substrate and/or support. In some embodiments the ions may be attracted towards the drum by a negative voltage, which repels electrons within the plasma.

The substrate of embodiments of the invention may comprise a web of film of material such as a plastics material.

The apparatus may further comprise a delivery device arranged to deliver radiation curable material to the substrate.

The energy level 3.6eV is that needed to break a carbon-carbon single bond in saturated precursor materials, such as parylene, in order to induce polymerisation.

The lower energy limit may be at least 6.5eV. The energy level 6.5eV is that needed to break a carbon-carbon double bond in precursor materials, such as acrylates, in order to induce polymerisation.

The upper energy limit may be no greater than 100eV. This may reduce ion impact on the substrate and/or layer of condensed radiation curable material.

Although it is known that an electron flux extracted from a low pressure gas plasma and having an energy level between 6.5eV and 300eV can be used for curing a radiation curable material, the present inventors discovered that an ion flux having an energy range between 3.6eV and 250eV can be used to cure a radiation curable material. This was unexpected due to the prior art teaching that an ion flux having an energy level within the claimed range would not cure a condensed film having a minimum thickness of 0.01µm and moving at a rate of at least 50m/min because of the relatively poor penetration characteristics ions exhibit in comparison with electrons and the limited exposure time for the thickness of film. This suggests that although the surface adjacent to the ion flux could be fully cured, the surface adjacent to the substrate would be uncured or partially cured, giving rise to a weak surface layer which would have poor adhesion to the substrate.

Moreover, the relatively high momentum of ions has been known to cause damage to surfaces of substrates such as webbing and/or a film of radiation curable material. Indeed, taking information from the Handbook of Sputter Deposition Technology (p50, ISBN 9780815512806), it is known that the damage threshold for a film of radiation curable material can be as low as 30eV. As such, the prior art teaches away from using an ion flux having an energy level above 30eV, and anything below this level would be viewed as being particularly unsuitable due to the perceived penetration problem referred to above.

An advantage to using an ion flux having an energy level between 3.6eV and 250eV for the curing, rather than an electron flux having an energy level between 6.5eV and 300eV, is that any overspray of radiation curable material or re-evaporate thereof will also be cured due to species generated at earthed surfaces inside the process chamber.

In some embodiments the apparatus may be arranged to deliver one or more further gases along with the primary gas used to create the plasma, the further gas(es) being arranged to perform one or more additional functions such as removing unwanted species from the web, or including certain species in the developing polymer film on the web substrate. The use of an ion flux as the primary curing initiator has a further advantage over the use of an electron flux in that the ion flux may contain ionised species from both the primary plasma gas and the further plasma gas, meaning that, even with the plasma spaced from the web substrate, the further gas can act upon the web or polymer film though migration of its ions. In one example, hydrogen could be used to passivate the surface. In an other example, nitrogen could be introduced as the further gas in order to introduce a reactive bonding species aimed at increasing or changing the cross-linking within the film.

In embodiments of the invention the plasma gas and one or more additional gases may be delivered to the plasma defining region by one or more gas delivery conduits.The delivery device may be arranged to deliver vaporised or atomised radiation curable material such that it condenses on the substrate.

The delivery device may deliver the radiation curable material to the substrate concurrently or sequentially with respect to the delivery of the ion flux.

The radiation curable material may comprise a saturated or unsaturated radiation curable material. In some embodiments the unsaturated radiation curable material comprises acrylate.

The support may be arranged to move the substrate at a line speed of at least 50 meters per minute.

The delivery device may be arranged to deliver the condensed radiation curable material to provide a thickness in the range 0.001µm to 50µm and preferably in the range of 0.01µm to 1µm.

The apparatus may be arranged to provide a unit energy dose, which may be an average unit energy dose, which is no greater than 15 J/cm², preferably no greater than 13 J/cm², more preferably no greater than 0.1 J/cm² and even more preferably no greater than 0.04 J/cm². Generally speaking, a lower unit energy dose may enable a faster line speed for the web substrate.

The apparatus may further comprise a magnet array arranged to spatially define the plasma.

The support may comprise a rotatable drum.

The magnet array may be arranged to define a magnetic field configured to influence the generated plasma to form:
a first race track portion that is adjacent to a first surface region of the drum; and
a second race track portion that is adjacent to a second surface region of the drum,
wherein the first and second surface regions are circumferentially spaced from one another.

The first and second surface regions may be circumferentially spaced from one another by at least about 20 mm. In other embodiments of this aspect or other aspects of the invention, the first and second surface regions may be rotationally spaced from one another by an angle of at least about 22.5°, at least about 45°, at least about 90°, or at least about 135°.

The magnet array may comprise a first magnet assembly arranged to define the first race track portion and a second magnet assembly arranged to define the second race track portion. Each magnet assembly may comprise one or more magnets.

The magnet array may comprise a first magnet assembly arranged to define a race track comprising the first and second race track portions.

The magnet array may be arranged to define one or more further race track portions, each race track portion being adjacent to the surface of the drum and circumferentially spaced from each other race track portion by at least 20mm.

In some embodiments the apparatus may comprise a delivery device arranged to deliver the radiation curable material to the substrate between race tracks.

In some embodiments the apparatus may comprise a delivery device may be arranged to deliver the radiation curable material to the substrate between race track portions.

The magnet array may be disposed within the drum.

The drum may define an electrode arranged to generate the plasma.

In accordance with a second aspect of the present invention, there is provided a process according to claim 7.

The process may include the step of condensing a radiation curable material on the substrate and curing the radiation curable material with the ion flux extracted from the plasma.

The substrate may be moving at a rate or instantaneous velocity of at least 50m/min and preferably at least 5m/s and more preferably at least 10m/s.

The condensed radiation curable material may have a thickness in the range 0.001µm to 50µm and preferably in the range of 0.01µm to 1µm.

The apparatus may be arranged to provide a unit energy dose, which may be an average unit energy dose, which is no greater than 15 J/cm², preferably no greater than 13 J/cm², more preferably no greater than 0.1 J/cm² and even more preferably no greater than 0.04 J/cm². Generally speaking, a lower unit energy dose may enable a faster line speed for the web substrate.

The step of generating a plasma may comprise exciting a gas to form a gas plasma.

The ion flux may be extracted from the plasma with a driving voltage that is positive relative to the substrate and/or support. The driving voltage may be provided on the opposite side of the plasma with respect to the substrate and/or support. In some embodiments the ions may be attracted towards the drum by a negative voltage.

The plasma may be spatially defined by a magnet array. The moving substrate may be transported by a rotating drum.

A magnetic field may be provided that is configured to influence the generated plasma to form:
a first race track portion that is adjacent to a first surface region of the drum; and
a second race track portion that is adjacent to a second surface region of the drum,
wherein the first and second surface regions are circumferentially spaced from one another.

The first and second surface regions may be circumferentially spaced from one another by at least 20 mm.

A first magnet assembly may define the first race track portion and a second magnet assembly may define the second race track portion. Each magnet assembly may comprise one or more magnets.

A first magnet assembly may define a race track comprising the first and second race track portions.

One or more further race track portions may be defined, each race track portion being adjacent to the surface of the drum and circumferentially spaced from each other race track portion by at least 20mm.

The magnet array may be disposed within the drum.

The drum may define an electrode arranged to generate the plasma.

### Description of the Drawings

By way of example only, certain embodiments of the invention will now be described by reference to the accompanying drawings, in which:
Figure 1 is a schematic drawing of apparatus for carrying out a process according to a first embodiment of the invention;
Figure 2 is a schematic drawing of apparatus for carrying out a process according to a second embodiment of the invention;
Figure 3 is a schematic drawing that illustrates radiation and vapour flows;
Figure 4 is a schematic drawing showing configuration for sequential delivery and cure;
Figure 5 is a schematic drawing showing a further configuration for sequential delivery and cure;
Figure 6 is a schematic drawing that illustrates a plasma source for use in Figures 1 to 5;
Figure 7 is a schematic drawing of apparatus according to a further embodiment of the invention;
Figure 8 is a schematic drawing of apparatus according to a further embodiment of the invention;
Figure 9 is a schematic drawing of apparatus according to a further embodiment of the invention;
Figure 10 is a schematic drawing of apparatus according to a further embodiment of the invention;
Figure 11 is a schematic drawing of apparatus according to a further embodiment of the invention;
Figure 12 is a schematic drawing of apparatus according to a further embodiment of the invention;
Figure 13 is a schematic drawing of apparatus according to a further embodiment of the invention;
Figure 14 is a diagram illustrating a 'narrow' racetrack; and
Figure 15 is a diagram illustrating a 'wide' racetrack.

### Embodiments of the Invention

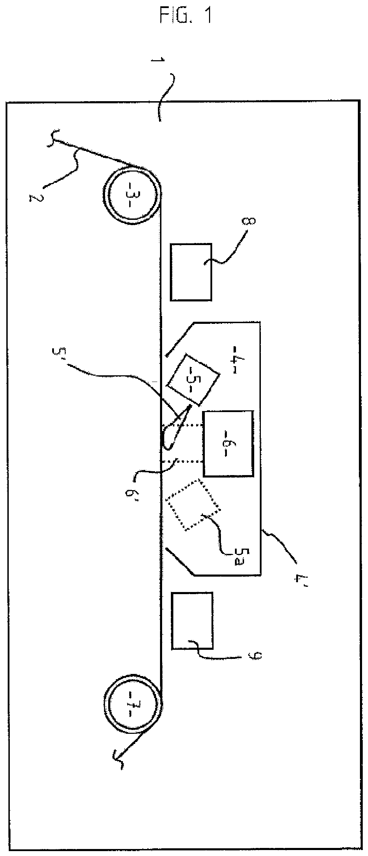

The apparatus in Figure 1 is housed in a vacuum chamber 1. A web 2 to be treated is fed over idle rollers 3, 7 between web unwind and rewind stations (not shown). The web is fed past a deposition station 4 defined by an enclosure 4' in which is housed a device 5 that generates a directional beam 5' of a radiation curable material, and a low pressure gas plasma source 6 that generates a directed ion flux 6' . The flux 6' may comprise cations and other positively charged or non-charged particles and species, but the positively charged ions are the primary curing or processing initiator. The ionisation fraction of the plasma might typically be 10⁻⁵ to 10⁻¹. The beam of radiation curable material, such as a polymer precursor vapour or atomised liquid, is directed at the web 2 as it passes below device 5, and the plasma source 6 simultaneously directs the ion flux 6' at the web 2 to be incident on the web generally concurrently with the beam 5'. The beam 5' and flux 6' overlap so that the overlap region is exposed to the ion radiation during delivery, thereby to initiate curing as the vapour is delivered to the web 2. The enclosure 4' serves to support a differential pressure between the inside of the enclosure and the vacuum chamber 1 so as to control escape of the precursor vapour and process gases outside of the enclosure. The apparatus can optionally have surface treatment stations 8 and 9 to enhance the properties of the web prior to and after the deposition station 4.

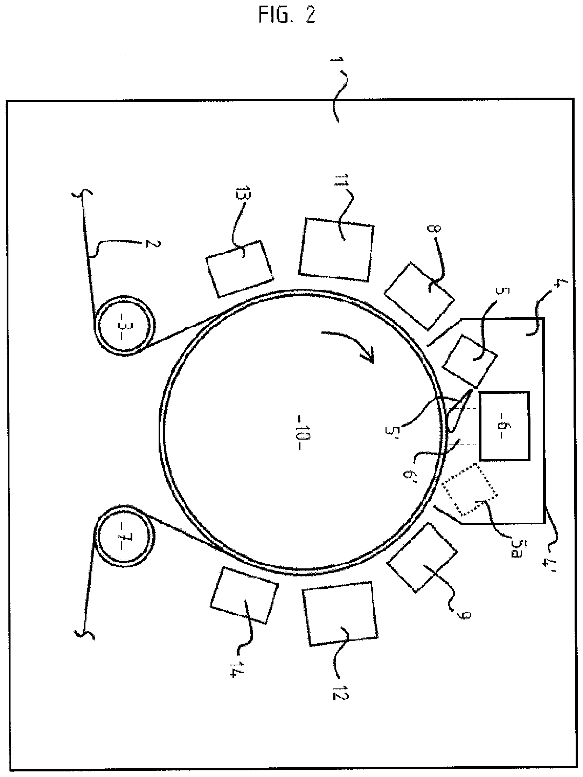

An alternative embodiment of the invention is illustrated in Figure 2 in which the linear feed of the web 2 between rollers 3, 7 is supplemented by a rotating drum feed 10. The rotating drum 10 allows additional treatment processes to take place, e.g., further depositing stations 11, 12 for coating metallic or non-metallic compounds before and after the deposition station 4, and treatment stations 13, 14 to enhance the properties of the film before and after the optional depositing stations 11 and 12.

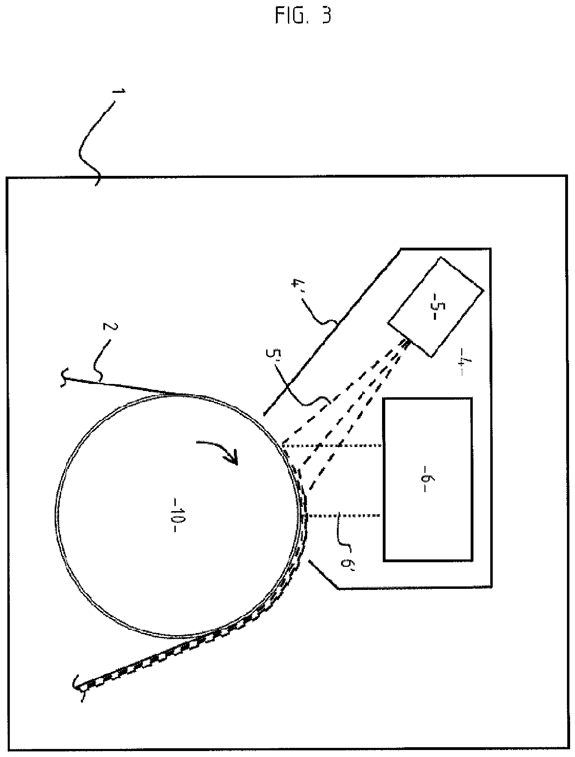

As shown in Figures 1 and 2, the radiation curable material deposition device 5 may be relocated to 5a, which indicates an alternative spatial configuration for delivery relative to the radiation source 6 so that it is downstream rather than upstream of the radiation 6 in the movement of the web 2. However, the precursor beam 5' would still be angled to overlap the ion flux 6' in a similar manner shown in Figure 3. This shows the pattern of the precursor beam 5' and ion flux 6', and how these beams overlap in space and are incident concurrently on the web 2 so that a coating is progressively deposited and cured as the web passes the deposition station 4. Such an overlapping configuration may be used in embodiments of the invention.

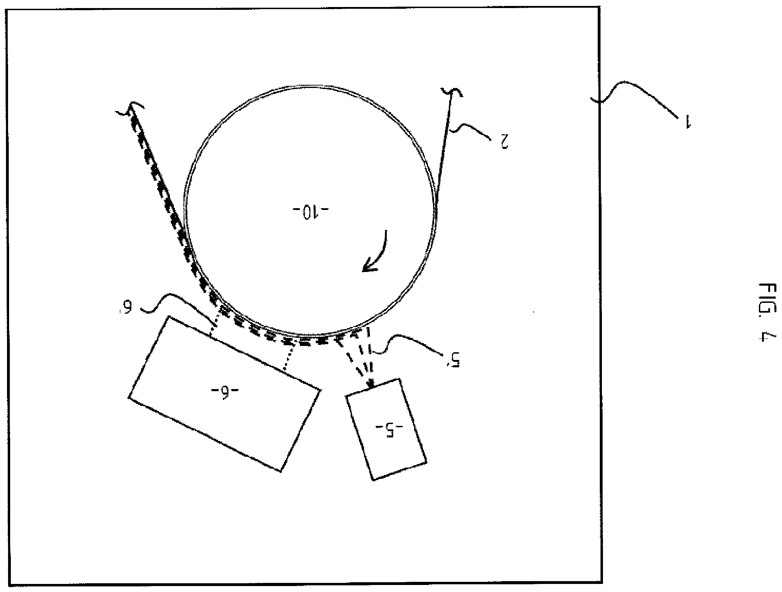

Figure 4 shows an embodiment of the invention in which the deposition device 5 has been repositioned away from the ion flux source 6. In Figures 1 to 3, the deposition and curing occurs concurrently in space and time onto the web 2, whereas in the illustrated embodiment, the web 2 first passes the deposition beam 5' and transports the uncured deposited material to the ion flux 6' to be cured. Although the deposition device 5 and ion flux source 6 are active concurrently in time, they are acting sequentially upon the web 2, and so the respective beams 5' and 6' are not spatially concurrent.

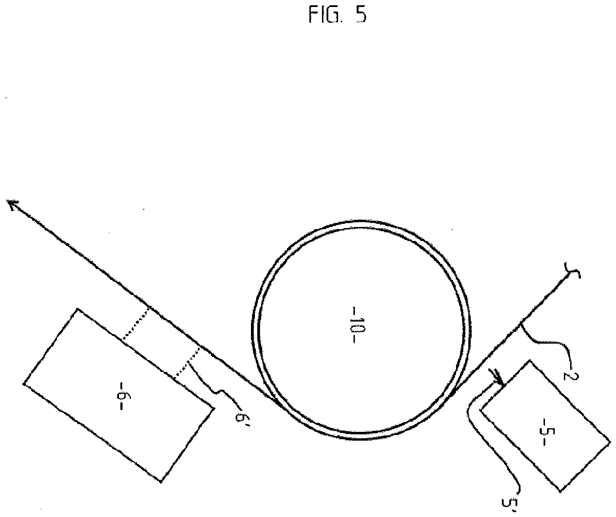

Figure 5 shows a further embodiment of the invention in which the deposition device 5 is repositioned to deliver the vapour stream 5' onto a free span portion of the moving web 2. The ion flux source 6 is arranged to cure in a free span position after a roller 10. This configuration is similar to that referred to in Example 1 below.

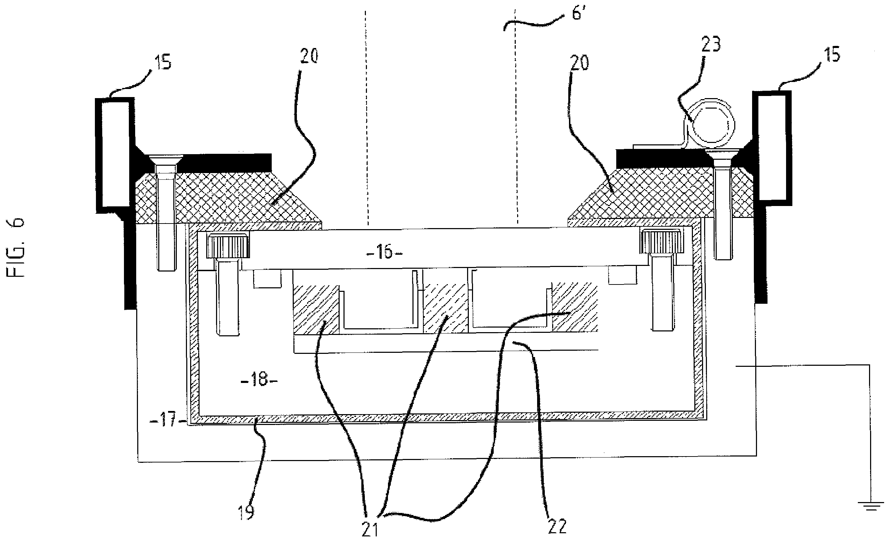

Figure 6 shows a plasma generator 6 suitable for use in embodiments of the invention described herein. In the illustrated example, the plasma generator 6 is a low pressure gas plasma. The pressure of this process will determine not only the mean free path of any molecule within the plasma zone, but also the ion energy distribution dependent upon the electric field used. Reference Handbook of Plasma Processing Technology pages 38-43 (ISBN0-8155-1220-1). The plasma is generated between a cathode 15, which is water cooled, and a reaction plate 16. An outer core 17 is insulated from an anodic inner core 18, which is also water cooled, by an insulating layer 19. Spatial separation between the anode and cathode is supplied by insulators 20. A magnet array 21 of a magnetron is arranged with an outer set of magnets in opposite polarity to a centre set of magnets on a yoke plate 22 to which they are magnetically attached to create a magnetic field to trap the ionised gas. A plasma gas is supplied to the plasma area from a gas inlet pipe 23. The magnet array 21 operates as a magnetron to enhance ionisation of the plasma in the glow discharge in the region of the reaction plate 16. A driving voltage is applied to the anode 18 and is electrically connected to the reaction plate 16, which is positive relative to the web 2 so as to direct the ion flux 6' towards the web 2.

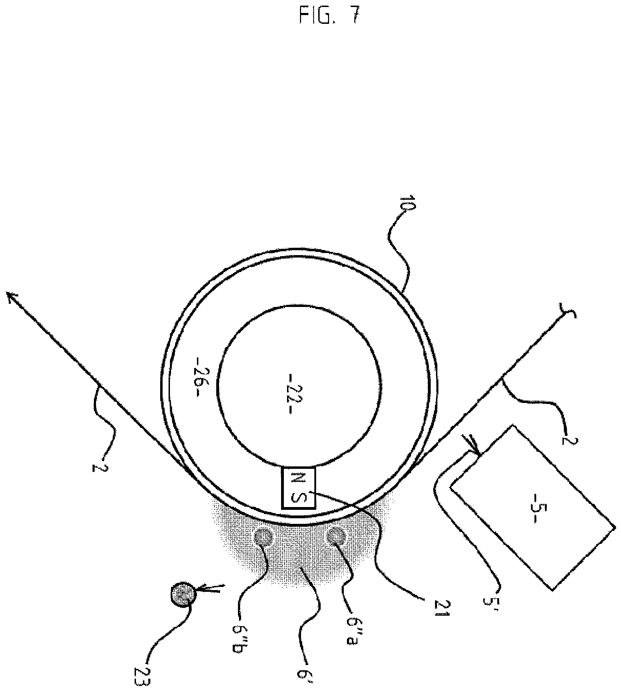

In other embodiments, any suitable ion flux source may be provided, and different means may be employed to direct the ion flux towards the substrate. For example, as will be described in more detail below with reference to Figures 7 to 13, the support for transporting the substrate may define a cathode to attract the ion flux towards the web. Moreover, although the ion flux has been illustrated as being extracted from a plasma and directed towards the web, in other embodiments the plasma may be defined adjacent to the substrate and the electrons and other negatively charged particles and species may be extracted from the plasma away from the substrate and web.

Figure 7 shows an embodiment of the invention in which the rotating drum 10 defines a cathode arranged to attract the ion flux 6' towards the web 2. The system is housed in a vacuum chamber (not shown). The housing enables the operating pressure to be set to an appropriate level observed to be ranging between 10-4 and 10-0 millibar (mbar), but preferentially ranging between 10⁻³ and 10⁻¹milibar (mbar). The housing may also define an anode for the generation of plasma between the anode and the cathodic drum 10. The plasma is formed from a gas, such as Argon, supplied via a gas inlet 23. As with the embodiments illustrated in Figures 4 and 5, the precursor is applied to the web 2 upstream with respect to the curing zone by a device 5 that generates a directional beam 5' of a radiation curable material.

The drum 10 has an interior space 26, which may be water cooled. The drum 10 is rotatably mounted on a stationary yoke 22 disposed within the interior space 26. The stationary yoke 22 supports a magnet array 21. The magnet array 21 is arranged to produce closed loop magnetic flux lines that interact with the ion flux 6' to define relatively narrow 'race track' of high density ion flux having portions 6"a, 6"b that are located in close proximity to the web 2. The inventors have discovered that the position of the magnet relative to the outer surface of the drum 10 affects the configuration, in including the separation, of the discrete race track portions. Generally speaking, the discrete race track portions are relative close together when the magnet is relatively close to the drum surface, and relative widely spaced when the magnet is located away from the drum surface, closer to the central axis of the drum.

In the illustrated embodiment, the web 2 shields the cathode roller 10 from the ion flux 6'; this is advantageous because it inhibits oxidisation and fouling of the cathode 10. In such embodiments, the radiation source 6 should be powered by an AC supply, preferably operating within the radio frequency (RF) range; for example, 40-320kHz. In some embodiments the voltage source may be an AC source having any suitable frequency, such as 50Hz.

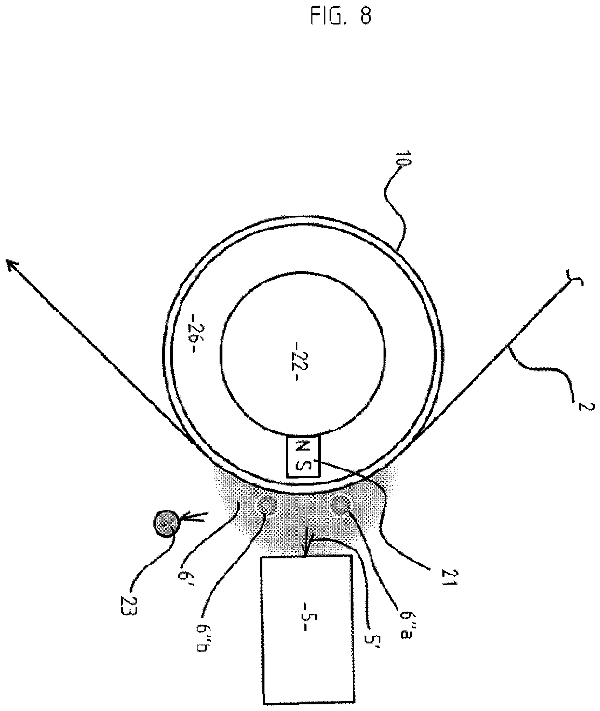

Figure 8 shows an alternative embodiment of the invention that is similar to the embodiment of Figure 7, but in which the precursor is applied to the web 2 through the curing zone by a device 5 that generates a directional beam 5' of a radiation curable material. As such, the curing in this embodiment occurs concurrently with the delivery of precursor material.

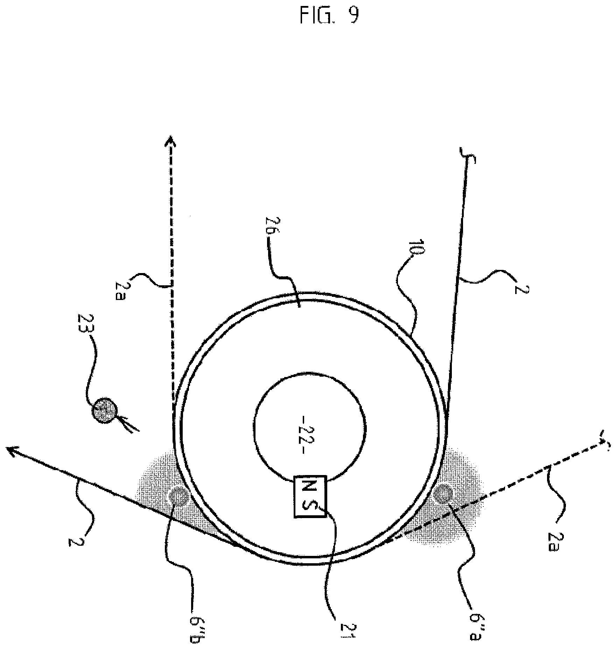

Figures 9 to 12 show alternative embodiments of the invention in which the magnet array 21 is arranged and configured to produce a plurality of discrete race track regions or portions around the surface of the roller 10. Put another way, the magnet array 21 is arranged to define a closed loop race track that has a number of distinct portions that each pass close to, or contact, the surface of the drum 10, and each of the distinct race track portions are spatially separated from one another by a distance defined by the magnetic array 21 which in some embodiments can be 20-40mm. This advantageously enables the discrete race track portions to be used for different purposes, such as the treatment or curing of opposite faces of the web 2, or pre-treating the web 2 prior to the delivery of precursor followed by curing thereof.

In the embodiment of Figure 9, the magnet array 21 consists of a single magnet assembly arranged to define a relatively wide race track that is in close proximity to the drum 10 at two circumferentially spaced portions 6"a, 6"b. A magnet assembly of embodiments of the present invention may comprise one or more magnets. The centre points of the race track portions 6"a, 6"b are rotationally spaced about the drum axis by approximately 135°. The pathway of the web 2 is arranged such that the first race track portion 6"a acts upon a first face of the web 2, and the second race track portion 6"b acts upon the opposite face of the web 2. In the first example, in which the web 2 is shown in solid line, the top surface of the web 2 is exposed to the first race track portion 6"a, due to the first race track portion 6"a being positioned at a location where the web 2 is supported by the drum 10, and the bottom surface of the web 2 is exposed to the second race track portion 6"b, due to the second race track portion 6"b being located in close proximity to the drum 10 at a location where the web 2 is no longer supported by the drum 10, but is still close to the second race track portion 6"b. The second example, shown with the web 2a in dashed line, shows the opposite configuration in which the web 2 has the underside surface exposed before the top surface to the respective regions of high density ion flux.

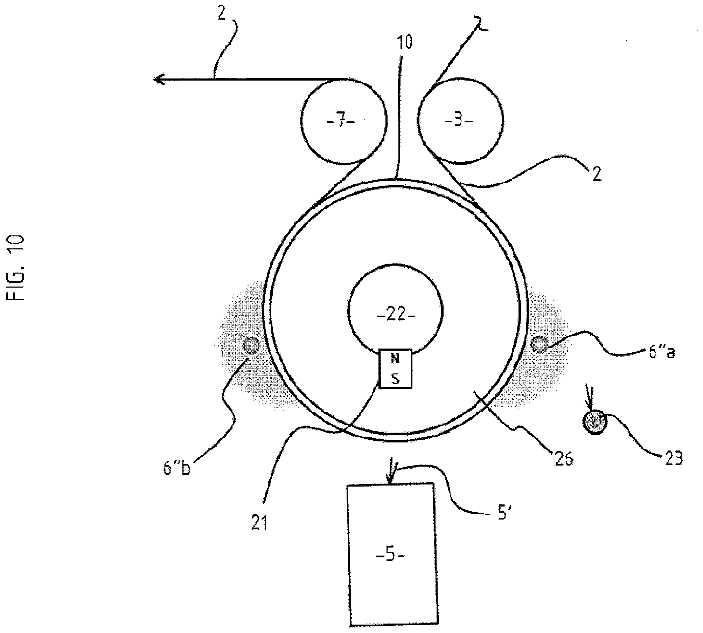

The embodiment of Figure 10 is similar to that shown in Figure 9. However, in the embodiment of Figure 10, the race track portions 6"a, 6"b are each positioned at a location where the web 2 is supported by the drum 10 so as to be exposed to the top surface of the web 2. A pair of tensioning rollers 3,7 may be provided to wrap the web 2 around approximately 270° of the drum. The first race track portion 6"a is arranged to pre-treat the top surface of the web 2 to improve surface adhesion. The second race track portion 6"b is arranged to define a curing zone adjacent the top surface of the web 2. Precursor is applied to the top surface of the web 2, between the race track portions 6"a, 6"b, upstream of the curing zone, by a device 5 that generates a directional beam 5' of a radiation curable material.

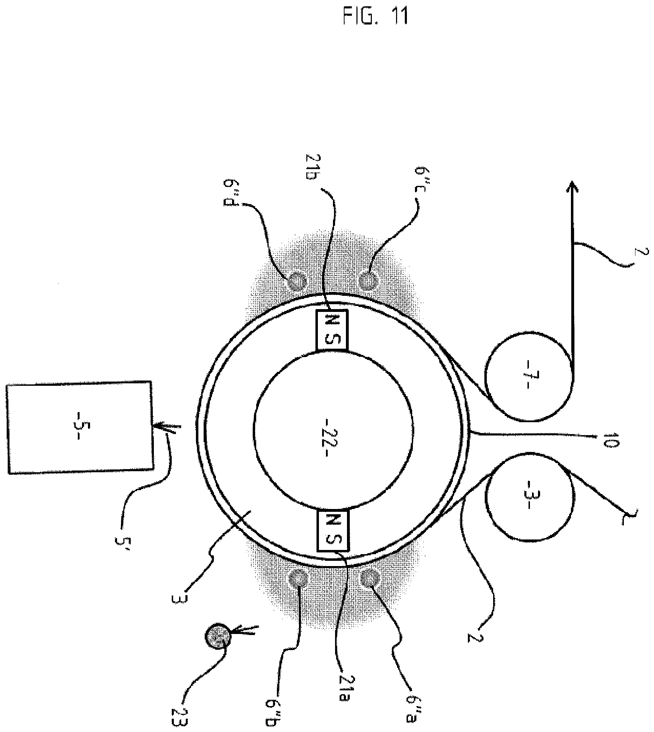

The embodiment of Figure 11 is similar to that shown in Figure 10. However, the magnet array 21a, 21b of the embodiment shown in Figure 11 consists of two magnet assemblies, each arranged to define relatively narrow race track portions 6"a, 6"b and 6"c, 6"d. The first magnet assembly 21a is located on a first side of the yoke 22 and arranged to define a first racetrack 6"a, 6"b adjacent to the drum surface 10 on a first side thereof. The second magnet assembly 21b is located on a second side of the yoke 22 and arranged to define a second racetrack 6"c, 6"d adjacent to the drum surface 10 and centred at a location that is rotationally spaced around the drum surface 10 with respect to the centre of the first race track portion as defined by 6"a, 6"b by approximately 180°. Precursor is applied to the top surface of the web 2, between the race track portions 6"a, 6"b and 6"c, 6"d, upstream of the curing zone define by the second race track portion 6"c, 6"d, by a device 5 that generates a directional beam 5' of a radiation curable material.

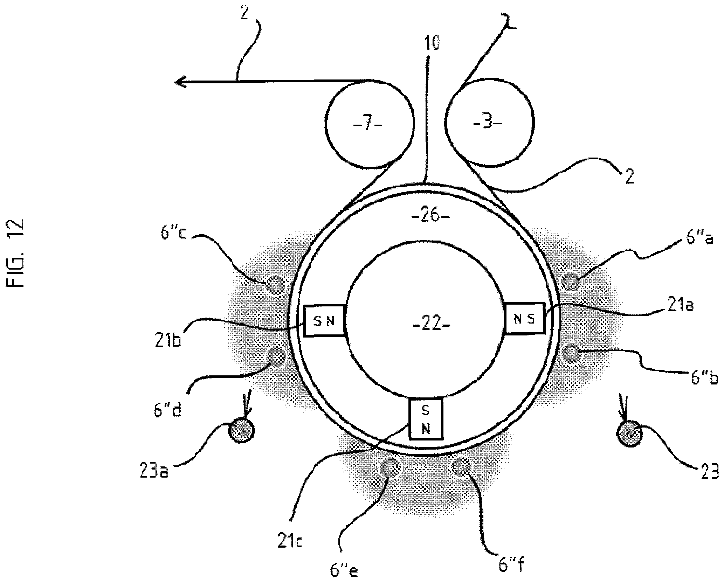

The embodiment of Figure 12 is similar to that shown in Figure 11. However, the magnet arrays 21a, 21b and 21c of the embodiments shown in Figure 12 are each arranged to define a race track portion at 6"a, 6"b, at 6"c, 6"d and at 6"e, 6"f. The first and second magnet assemblies 21a, 21b are identical to those described with reference to Figure 11. The third magnet assembly 21c is disposed between the first and second magnets 21a, 21b, in place of the device 5, and arranged to define a third race track portion at 6"e, 6"f adjacent to the drum surface 10 and centred at a location that is rotationally spaced around the drum surface 10 with respect to the centre first race track portion 6"a, 6"b by approximately 90°. In addition to the gas inlet 23, the illustrated embodiment includes second gas inlet 23a that is spaced from the first gas inlet 23. This may be advantageous if the drum 10 is particularly large and it is derisible to perform plasma processing around the drum 10, or if different gases are to be used to generate distinct, different plasmas.

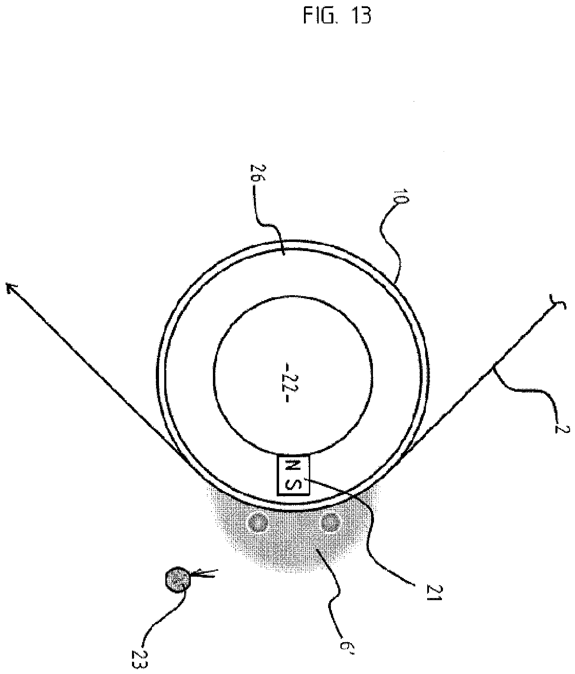

The embodiment of Figure 13 is similar to that shown in Figures 7 & 8. However the device 5 that generates a directional beam 5' of a radiation curable material has been omitted. Such an embodiment may be used to pre-treat the web 2 prior to subsequent processing steps.

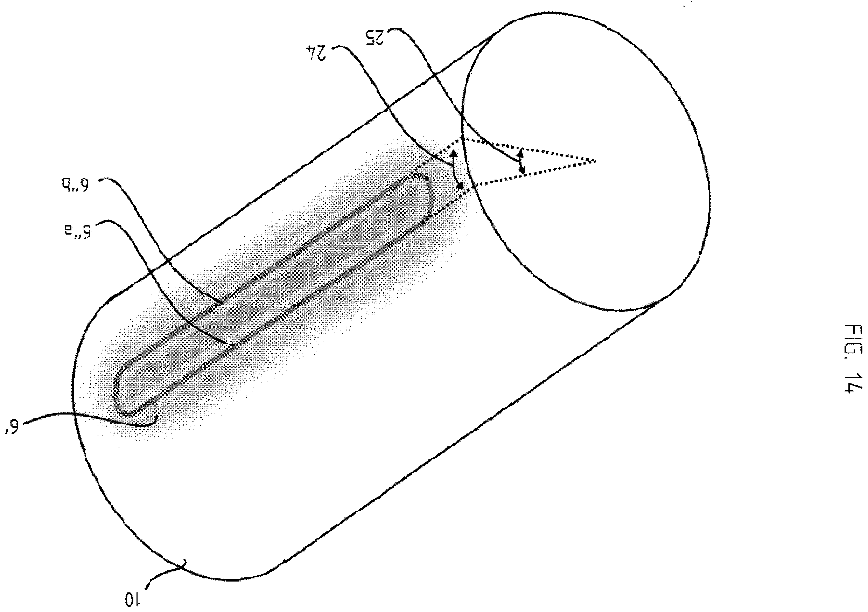

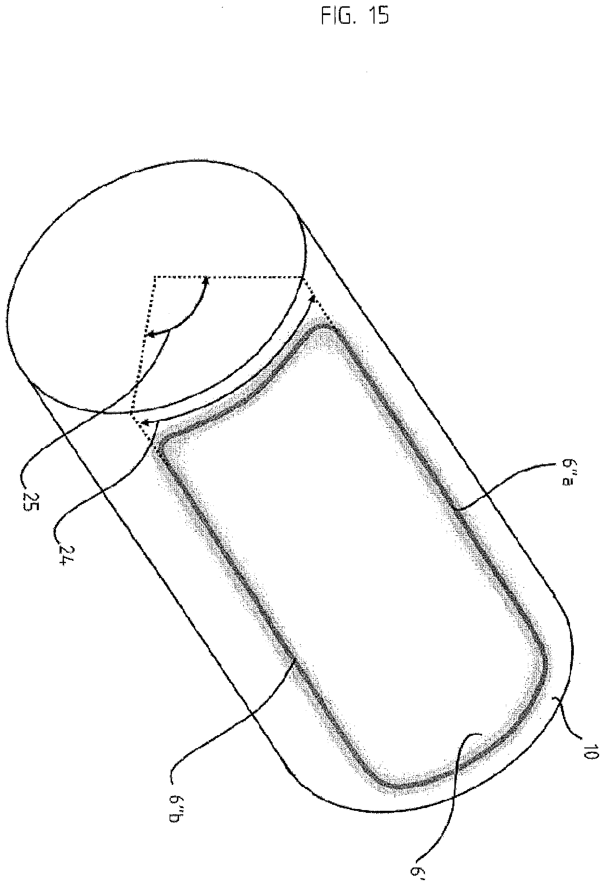

The race track portions of embodiments of the invention such as those described with reference to Figures 7 to 13 preferably extend so as to act upon a significant portion of the height of the circumferential face of the drum 10, as illustrated in Figures 14 and 15.

Figure 14 shows a 'narrow' race track comprising race track portions 6"a and 6"b. Thus, race track portions both 6"a and 6"b are two parts of the same high density ion flux. The circumferential separation 24 and the rotational separation 25 are small. The circumferential separation 24 can be a low as 20mm on the drum surface and the rotational separation 25 is dependent on the roller 10 diameter.

Figure 15 describes a 'wide' race track comprising race track portions 6"a and 6"b. However, the magnet array (not shown) inside the drum 10 has been arranged and configured such that the circumferential separation 24 and the rotational separation 25 are relatively large. The rotational separation can be as much as 180° (greater than 180° being simply a mirror image of the reflectionally symmetrical smaller angle) and the circumferential separation is dependent on the roller 10 diameter.

Embodiments of the invention having a magnet array 21 disposed within the drum cavity 26 advantageously enable a magnetically enhanced plasma to be defined with a small mechanical footprint, due to the magnets being contained inside the drum 10. This lends itself to retrofitting such a drum in existing plasma processing devices. In some embodiments, separate processing functions can be achieved with a magnet array consisting of a single magnet assembly that is conveniently housed within the drum 10. In some embodiments, such as those described with reference to Figures 9 and 10, race track portions can be defined at a plurality of discreet positions around the drum using a single magnet assembly.

Embodiments of the invention may include a magnet array arranged to form one or more race tracks having any suitable configuration.

Thus, embodiments of the invention provide a low energy ion flux that can be used for curing or processing steps. An advantage to using an ion flux having an energy level between 3.6eV and 250eV for the curing, rather than an electron flux having an energy level between 6.5eV and 300eV, is that any overspray of radiation curable material or re-evaporate thereof will also be cured due to species generated at earthed surfaces inside the process chamber.

The functional element of the radiation curable precursor is any saturated or unsaturated material capable of being vaporised or atomised and sprayed onto the substrate, and also capable of being polymerised by the ion flux. Precursors can be organic or inorganic and include unsaturated organic materials, silicon-based materials, halogen-based materials, organo-metallic composites etc, with acrylates such as tripropylene glycol diacrylate or isobornyl acrylate being preferred. Most polymerisable materials described in the art can be used in the process. The vaporised or atomised material may optionally include other radiation curable or non-curable components to provide functionality such as adhesion promotion, dimensional stability, mechanical properties, colour, antibacterial properties, hydrophillia, hydrophobia, electrical conductivity etc.

The thickness of the precursor film or the cured polymer coating can be any suitable value. For example, in some embodiments the value may be at least 0.001µm. In some embodiments, the value is in the range 0.001µm - 50µm, and preferably 0.01µm to 1µm, the preferred thickness largely being decided on the basis of the function of the polymer layer in the intended application, and cost constraints, rather than constraints arising from the process. For example, for barrier packaging applications, the function of the polymer layer is to protect the barrier coating (i.e. the aluminium or aluminium oxide) against physical damage or abrasion. In this case, the lower limit of thickness of the polymer layer may be around 0.02µm, as below this there is insufficient protection. The upper limit may be subjective, as above about 1µm, the benefit of mechanical protection will begin to be outweighed by the risk of delamination.

Any web substrate which can be handled by the equipment can be used in the invention. Substrates can include a wide variety of commercially available thermoplastic films (including polyesters such as polyethylene terephthalate (PET) or polyethylene naphthalate (PEN) or blends or coextrusions thereof), polyamides (including nylon 6 and nylon 6.6), polyolefines (including polypropylene and high and low density polyethylene) and other thermoplastic films known in the art. Non-thermoplastic films, including biodegradable films and films derived from renewable resources, such as polylactic acid or cellulose-based materials including cellulose diacetate, also known as cellulose acetate, may also be used. Thermoset polymer films, such as polyimides may also be used. Fibrous, non-woven or woven substrates (such as paper or textiles) may also be used. The invention is not limited by this list of web substrates.

The process of embodiments of the invention may be a "high speed process", meaning that the web substrate is moving at a speed of at least 50 m/min. It is preferred that the web is moving at a speed of at least 5 m/s, and more preferably that that the web is moving at a speed of at least 7 m/s. In some embodiments of the invention, the web may form part of a reel to reel process.

Embodiments of the invention may use any easily ionisable inert gases to generate the plasma; for example argon, helium and neon, or other non-reactive gases or reactive gases including nitrogen or oxygen. Combinations of gases could be used to tailor the gas to specific applications. The gas used to generate the plasma is distinct from the radiation curable monomer. This may provide a more controllable and practicable method compared to generating a plasma using the monomer itself, due to the quantities involved. For example, the 'high' flow rates, such as 25ml per minute, used in embodiments of the invention would cause considerable vacuum problems if ionised in a plasma.

One or more further gases may be added to the primary gas used to create the plasma, the further gas(es) being arranged to perform one or more additional functions such as removing unwanted species from the web, or including certain species in the developing polymer film on the web substrate. The use of an ion flux as the primary curing initiator has a further advantage over the use of an electron flux in that the ion flux may contain ionised species from both the primary plasma gas and the further plasma gas, meaning that, even with the plasma spaced from the web substrate, the further gas can act upon the web or polymer film though migration of its ions. In one example, hydrogen could be used to passivate the surface. In an other example, nitrogen could be introduced as the further gas in order to introduce a reactive bonding species aimed at increasing or changing the cross-linking within the film.

The moving substrate is exposed to the ion flux for a period of time inversely proportional to the web speed. This period of time shall be referred to as the 'dwell time' and this can be influenced by the web speed and the length of web being exposed to the flux, which shall be referred to as the 'dwell length'. It is preferred that the dwell length be as short as is reasonably practicable. A unit power dose measured in W/cm² experienced by the web can be calculated by dividing the operating power of the plasma generator by the cross sectional area of the ion flux. The unit power dose can be used with the dwell time to establish a unit energy dose on the web, measured in J/cm². With a known flow rate of radiation curable precursor and width of delivery the energy dose per unit precursor can be attained.

The plasma generator used in embodiments of the present invention may be connected to a an AC or a DC power supply. Depending on the power supply used, it is possible to create and control an ion flux having the stated energy ranges, such as an energy level that is no greater than 250eV or an energy level that is no greater than 100eV. For example, the voltage applied to the plasma generator may define the maximum energy level and as such applying 250V results in an ion flux having a maximum energy level of 250eV.

In embodiments of the invention it is preferred that the unit energy dose, described above, is no greater than 15 J/cm², more preferably no greater than 13 J/cm², and in some embodiments the unit power may be no greater than 0.1 J/cm². It is preferred that the dwell length, as described above is between 5-50cm and even more preferred to be 10cm. A short flux may undesirably limit the line speed of the web, whereas a long flux length may lead to undesirably high power consumption and impracticability of space. It is preferred that the dwell time be as low as possible whilst still giving full cure to ensure a high process efficiency.

The substrate can optionally be pre-coated or post-coated, vacuum deposited or printed with a wide variety of metals, metallic or non-metallic compounds and other materials, in order to achieve desired properties or effects. For non-transparent barrier applications, for example, substrates such as polyester films coated with a metal such as aluminium are especially preferred. For transparent barrier applications, substrates such as polyester films coated with a transparent metallic or non-metallic oxide, nitride or other compound (e.g. oxide of aluminium or oxide of silicon) are especially preferred. For electrical or electronic applications, the web substrate may be optionally pre-coated with a metal such as copper or another conductive inorganic or organic material, which however may be transparent or non-transparent. However, the invention is not limited to these specified coatings.

For very high barrier applications, a plurality of barrier layers, separated by polymer layers, is used, as this extends the diffusion pathway for gas or vapour between the permeable defects in each barrier layer. In this case, since the polymer layer is functioning as a separating layer between two metal or ceramic layers, and has little or no inherent barrier of its own, it should preferably be as thin as practicable, conducive with the requirements that it should be continuous, i.e. with no voids or defects, and have good surface smoothness to maximise the barrier of the second or subsequent barrier layer.

For optically variable devices, the function of the polymer layer is to generate light interference, and thus produce a "colour shift". For such applications, a coating thickness of approximately a quarter to half of the wavelength of the incident light is preferred but the invention is not limited by this thickness.

Materials manufactured by the invention are suitable for use in multiple different applications including: packaging applications; abrasion-resistant material or intermediate (in which the polymer coating prevents abrasion damage to any underlying functional layers during conversion or use); security or anti-counterfeit applications, including continuously optically variable devices; decorative applications, including continuously optically variable devices; functional industrial applications; and electrical or electronic applications (inclusive of static electricity dissipation).

Some more specific examples of embodiments of the invention will now be set out.

### Example 1

A planar magnetron such as that shown in Figure 4 was electrically connected to a DC power source such that the reaction plate 16 and inner core 18 were anodic and held at a power of 1kW. The voltage applied did not deviate beyond the range 220-240V throughout the experiment. The approximate energy dose on the web during this trial was 12J/cm². The surrounding electrode 15 and outer case 17 were connected to earth. An argon and oxygen gas mixture was delivered through the delivery 23. This curing plasma was positioned downstream of an acrylate delivery system. The delivery flow rate of the acrylate system was set to 15ml/min distributing an acrylate vapour over a 12µm thick PET substrate of 400mm width travelling at approximately 1 m/min. The process was run for approximately 10 minutes before venting. Upon checking the material, it was found to have excellent adhesion and resistant to flexing.

### Example 2

A roller magnetron similar to Figure 9 where the high density plasma (race track) zones 6"a, 6"b were rotationally spaced by approximately 135° was connected to an RF power source such that the entire roller surface was held at a power of 0.3kW over a magnetron area of 500×100mm. This plasma dose was therefore 0.6W/cm². The voltage applied stayed within the range of 180-220V during the experiment. The roller assembly was floated from earth. The delivery flow rate of the acrylate system was set to 10ml/min distributing an acrylate vapour over a 12µm thick PET substrate of 400mm width travelling at approximately 100m/min. This gave a 0.06s dwell time in the plasma, hence the approximate energy dose on the web during this trial was 3.6×10⁻²J/cm². The substrate subsequently travelled to a metallisation zone for an aluminium coating of between 2.0-2.5 optical density within the same machine. Both the acrylate system and metallisation processes occurred concurrently in time. The processes were run for approximately 5 minutes before venting. Upon checking the material, it was found to have excellent adhesion and oxygen and moisture barrier.

### Example 3

In this example, a simulated small roller magnetron similar Figure 12, was setup in a Bell Jar vacuum and utilised three magnetic arrays 21, space equally around the roller (rotationally spaced by 120°). The roller surface was connected to an RF power source running at a frequency of 175kHz and an approximate power of 100W. When in operation, three distinct race tracks formed on the surface of the 'roller' with the race track zone centres rotationally spaced by 120° around the surface in the same manner as the magnet arrays. This was sustained for approximately 5 minutes and was stable.

### Example 4

In this example, a roller magnetron similar to Figure 13 was used to plasma pre-treat a substrate prior to metallising. The roller surface was connected to an RF power source running at a frequency of 40kHz sustaining 0.3kW with a voltage ∼200V. The approximate energy dose on the substrate was 3.6×10⁻²J/cm². The substrate was subsequently exposed to a metallisation zone for an aluminium coating of between 2.0-2.5 optical density. The process was run for approx 10 minutes at a line speed of ~100m/min before venting. The material was checked and found to have excellent metal adhesion and oxygen and moisture barrier.

### Example 5

In a further experiment following the above example 4, the substrate line speed was reduced in stages to observe the level the substrate could endure before thermal degradation. Carbonisation of the web was observed at a web speed of ~ 0.25m/min. At ∼0.5m/min some film distortion was noted, above 1m/min no damage was observed on the substrate. The roller surface was connected to an RF power source running at a frequency of 40kHz sustaining 0.3kW with a voltage ~200V. At the point of observed thermal degradation, when run at approximately 0.25m/min line speed, giving a 24 second dwell time in the plasma, the energy dose to the substrate was 14.4J/cm².

The race track portions of embodiments of the invention such as those described with reference to Figures 7 to 13 preferably extend so as to act upon a significant portion of the height of the circumferential face of the drum 10, as illustrated in Figures 14 and 15.

Figure 14 shows a 'narrow' race track comprising race track portions 6"a and 6"b. Thus, race track portions both 6"a and 6"b are two parts of the same high density ion flux. The circumferential separation 24 and the rotational separation 25 are small. The circumferential separation 24 can be a low as 20mm on the drum surface and the rotational separation 25 is dependent on the roller 10 diameter.

Figure 15 describes a 'wide' race track comprising race track portions 6"a and 6"b. However, the magnet array (not shown) inside the drum 10 has been arranged and configured such that the circumferential separation 24 and the rotational separation 25 are relatively large. The rotational separation can be as much as 180° (greater than 180° being simply a mirror image of the reflectionally symmetrical smaller angle) and the circumferential separation is dependent on the roller 10 diameter.

Embodiments of the invention having a magnet array 21 disposed within the drum cavity 26 advantageously enable a magnetically enhanced plasma to be defined with a small mechanical footprint, due to the magnets being contained inside the drum 10. This lends itself to retrofitting such a drum in existing plasma processing devices. In some embodiments, separate processing functions can be achieved with a magnet array consisting of a single magnet assembly that is conveniently housed within the drum 10. In some embodiments, such as those described with reference to Figures 9 and 10, race track portions can be defined at a plurality of discreet positions around the drum using a single magnet assembly.

Embodiments of the invention having a magnet array 21 disposed within the drum cavity 26 can use any suitable means of plasma curing i.e. these embodiments are not limited to using an ion flux having an energy level between 3.6eV and 250eV for curing and/or processing.

Embodiments of the invention may include a magnet array arranged to form one or more race tracks having any suitable configuration.

Thus, embodiments of the invention provide a low energy ion flux that can be used for curing or processing steps. An advantage to using an ion flux having an energy level between 3.6eV and 250eV for the curing, rather than an electron flux having an energy level between 6.5eV and 300eV, is that any overspray of radiation curable material or re-evaporate thereof will also be cured due to species generated at earthed surfaces inside the process chamber.

The functional element of the radiation curable precursor is any saturated or unsaturated material capable of being vaporised or atomised and sprayed onto the substrate, and also capable of being polymerised by the ion flux. Precursors can be organic or inorganic and include unsaturated organic materials, silicon-based materials, halogen-based materials, organo-metallic composites etc, with acrylates such as tripropylene glycol diacrylate or isobornyl acrylate being preferred. Most polymerisable materials described in the art can be used in the process. The vaporised or atomised material may optionally include other radiation curable or non-curable components to provide functionality such as adhesion promotion, dimensional stability, mechanical properties, colour, antibacterial properties, hydrophillia, hydrophobia, electrical conductivity etc.

The thickness of the precursor film or the cured polymer coating can be any suitable value. For example, in some embodiments the value may be at least 0.001µm. In some embodiments, the value is in the range 0.001µm - 50µm, and preferably 0.01µm to 1µm, the preferred thickness largely being decided on the basis of the function of the polymer layer in the intended application, and cost constraints, rather than constraints arising from the process. For example, for barrier packaging applications, the function of the polymer layer is to protect the barrier coating (i.e. the aluminium or aluminium oxide) against physical damage or abrasion. In this case, the lower limit of thickness of the polymer layer may be around 0.02µm, as below this there is insufficient protection. The upper limit may be subjective, as above about 1µm, the benefit of mechanical protection will begin to be outweighed by the risk of delamination.

Any web substrate which can be handled by the equipment can be used in the invention. Substrates can include a wide variety of commercially available thermoplastic films (including polyesters such as polyethylene terephthalate (PET) or polyethylene naphthalate (PEN) or blends or coextrusions thereof), polyamides (including nylon 6 and nylon 6.6), polyolefines (including polypropylene and high and low density polyethylene) and other thermoplastic films known in the art. Non-thermoplastic films, including biodegradable films and films derived from renewable resources, such as polylactic acid or cellulose-based materials including cellulose diacetate, also known as cellulose acetate, may also be used. Thermoset polymer films, such as polyimides may also be used. Fibrous, non-woven or woven substrates (such as paper or textiles) may also be used. The invention is not limited by this list of web substrates.

The process of embodiments of the invention may be a "high speed process", meaning that the web substrate is moving at a speed of at least 50 m/min. It is preferred that the web is moving at a speed of at least 5 m/s, and more preferably that that the web is moving at a speed of at least 7 m/s. In some embodiments of the invention, the web may form part of a reel to reel process.

Embodiments of the invention may use any easily ionisable inert gases to generate the plasma; for example argon, helium and neon, or other non-reactive gases or reactive gases including nitrogen or oxygen. Combinations of gases could be used to tailor the gas to specific applications. The gas used to generate the plasma is distinct from the radiation curable monomer. This may provide a more controllable and practicable method compared to generating a plasma using the monomer itself, due to the quantities involved. For example, the 'high' flow rates, such as 25ml per minute, used in embodiments of the invention would cause considerable vacuum problems if ionised in a plasma.

One or more further gases may be added to the primary gas used to create the plasma, the further gas(es) being arranged to perform one or more additional functions such as removing unwanted species from the web, or including certain species in the developing polymer film on the web substrate. The use of an ion flux as the primary curing initiator has a further advantage over the use of an electron flux in that the ion flux may contain ionised species from both the primary plasma gas and the further plasma gas, meaning that, even with the plasma spaced from the web substrate, the further gas can act upon the web or polymer film though migration of its ions. In one example, hydrogen could be used to passivate the surface. In an other example, nitrogen could be introduced as the further gas in order to introduce a reactive bonding species aimed at increasing or changing the cross-linking within the film.

The moving substrate is exposed to the ion flux for a period of time inversely proportional to the web speed. This period of time shall be referred to as the 'dwell time' and this can be influenced by the web speed and the length of web being exposed to the flux, which shall be referred to as the 'dwell length'. It is preferred that the dwell length be as short as is reasonably practicable. A unit power dose measured in W/cm² experienced by the web can be calculated by dividing the operating power of the plasma generator by the cross sectional area of the ion flux. The unit power dose can be used with the dwell time to establish a unit energy dose on the web, measured in J/cm². With a known flow rate of radiation curable precursor and width of delivery the energy dose per unit precursor can be attained.

The plasma generator used in embodiments of the present invention may be connected to a an AC or a DC power supply. Depending on the power supply used, it is possible to create and control an ion flux having the stated energy ranges, such as an energy level that is no greater than 250eV or an energy level that is no greater than 100eV. For example, the voltage applied to the plasma generator may define the maximum energy level and as such applying 250V results in an ion flux having a maximum energy level of 250eV.

In embodiments of the invention it is preferred that the unit energy dose, described above, is no greater than 15 J/cm², more preferably no greater than 13 J/cm², and in some embodiments the unit power may be no greater than 0.1 J/cm². It is preferred that the dwell length, as described above is between 5-50cm and even more preferred to be 10cm. A short flux may undesirably limit the line speed of the web, whereas a long flux length may lead to undesirably high power consumption and impracticability of space. It is preferred that the dwell time be as low as possible whilst still giving full cure to ensure a high process efficiency.

The substrate can optionally be pre-coated or post-coated, vacuum deposited or printed with a wide variety of metals, metallic or non-metallic compounds and other materials, in order to achieve desired properties or effects. For non-transparent barrier applications, for example, substrates such as polyester films coated with a metal such as aluminium are especially preferred. For transparent barrier applications, substrates such as polyester films coated with a transparent metallic or non-metallic oxide, nitride or other compound (e.g. oxide of aluminium or oxide of silicon) are especially preferred. For electrical or electronic applications, the web substrate may be optionally pre-coated with a metal such as copper or another conductive inorganic or organic material, which however may be transparent or non-transparent. However, the invention is not limited to these specified coatings.

For very high barrier applications, a plurality of barrier layers, separated by polymer layers, is used, as this extends the diffusion pathway for gas or vapour between the permeable defects in each barrier layer. In this case, since the polymer layer is functioning as a separating layer between two metal or ceramic layers, and has little or no inherent barrier of its own, it should preferably be as thin as practicable, conducive with the requirements that it should be continuous, i.e. with no voids or defects, and have good surface smoothness to maximise the barrier of the second or subsequent barrier layer.

For optically variable devices, the function of the polymer layer is to generate light interference, and thus produce a "colour shift". For such applications, a coating thickness of approximately a quarter to half of the wavelength of the incident light is preferred but the invention is not limited by this thickness.

Materials manufactured by the invention are suitable for use in multiple different applications including: packaging applications; abrasion-resistant material or intermediate (in which the polymer coating prevents abrasion damage to any underlying functional layers during conversion or use); security or anti-counterfeit applications, including continuously optically variable devices; decorative applications, including continuously optically variable devices; functional industrial applications; and electrical or electronic applications (inclusive of static electricity dissipation).

Some more specific examples of embodiments of the invention will now be set out.

### Example 1

A planar magnetron such as that shown in Figure 4 was electrically connected to a DC power source such that the reaction plate 16 and inner core 18 were anodic and held at a power of 1kW. The voltage applied did not deviate beyond the range 220-240V throughout the experiment. The approximate energy dose on the web during this trial was 12J/cm². The surrounding electrode 15 and outer case 17 were connected to earth. An argon and oxygen gas mixture was delivered through the delivery 23. This curing plasma was positioned downstream of an acrylate delivery system. The delivery flow rate of the acrylate system was set to 15ml/min distributing an acrylate vapour over a 12µm thick PET substrate of 400mm width travelling at approximately 1 m/min. The process was run for approximately 10 minutes before venting. Upon checking the material, it was found to have excellent adhesion and resistant to flexing.

### Example 2

A roller magnetron similar to Figure 9 where the high density plasma (race track) zones 6"a, 6"b were rotationally spaced by approximately 135° was connected to an RF power source such that the entire roller surface was held at a power of 0.3kW over a magnetron area of 500×100mm. This plasma dose was therefore 0.6W/cm². The voltage applied stayed within the range of 180-220V during the experiment. The roller assembly was floated from earth. The delivery flow rate of the acrylate system was set to 10ml/min distributing an acrylate vapour over a 12µm thick PET substrate of 400mm width travelling at approximately 100m/min. This gave a 0.06s dwell time in the plasma, hence the approximate energy dose on the web during this trial was 3.6×10⁻²J/cm². The substrate subsequently travelled to a metallisation zone for an aluminium coating of between 2.0-2.5 optical density within the same machine. Both the acrylate system and metallisation processes occurred concurrently in time. The processes were run for approximately 5 minutes before venting. Upon checking the material, it was found to have excellent adhesion and oxygen and moisture barrier.

### Example 3

In this example, a simulated small roller magnetron similar Figure 12, was setup in a Bell Jar vacuum and utilised three magnetic arrays 21, space equally around the roller (rotationally spaced by 120°). The roller surface was connected to an RF power source running at a frequency of 175kHz and an approximate power of 100W. When in operation, three distinct race tracks formed on the surface of the 'roller' with the race track zone centres rotationally spaced by 120° around the surface in the same manner as the magnet arrays. This was sustained for approximately 5 minutes and was stable.

### Example 4

In this example, a roller magnetron similar to Figure 13 was used to plasma pre-treat a substrate prior to metallising. The roller surface was connected to an RF power source running at a frequency of 40kHz sustaining 0.3kW with a voltage ∼200V. The approximate energy dose on the substrate was 3.6×10⁻²J/cm². The substrate was subsequently exposed to a metallisation zone for an aluminium coating of between 2.0-2.5 optical density. The process was run for approx 10 minutes at a line speed of ~100m/min before venting. The material was checked and found to have excellent metal adhesion and oxygen and moisture barrier.

### Example 5

In a further experiment following the above example 4, the substrate line speed was reduced in stages to observe the level the substrate could endure before thermal degradation. Carbonisation of the web was observed at a web speed of ~ 0.25m/min. At ~0.5m/min some film distortion was noted, above 1m/min no damage was observed on the substrate. The roller surface was connected to an RF power source running at a frequency of 40kHz sustaining 0.3kW with a voltage ∼200V. At the point of observed thermal degradation, when run at approximately 0.25m/min line speed, giving a 24 second dwell time in the plasma, the energy dose to the substrate was 14.4J/cm².

## Claims

1. Apparatus for defining a plasma, the apparatus comprising:
a support (10) arranged to transport a moving substrate (2);
a plasma generator (6) arranged to generate plasma;
an electrode;
a delivery device (5) arranged to deliver radiation curable material to the substrate, the apparatus being arranged such that in use the radiation curable material condenses on the substrate,
**characterised by** a driving voltage electrically connected to said electrode arranged to bias, in use, positive ions within the plasma towards the moving substrate to form a positive ion flux (6') in which the positively charged ions are the primary curing initiators, wherein the ion flux has an energy level between 3.6eV and 250eV.

2. Apparatus according to any preceding claim, further comprising a magnet array (21) arranged to spatially define the plasma.

3. Apparatus according to any preceding claim arranged to provide a unit energy dose which is no greater than 15 J/cm².

4. Apparatus according to any preceding claim, wherein the support is arranged to move the substrate at a speed through the ion flux (6') such that the dwell time is no greater than 5 minutes.

5. Apparatus according to any preceding claim, further comprising a gas delivery system arranged to deliver a primary gas from which the plasma is generated and one or more further gases that are distinct from the primary gas.

6. A process for defining a plasma, the process comprising the steps of:
providing a moving substrate;
generating a plasma; and
**characterised by** biasing positive ions within the plasma towards the moving substrate to form a positive ion flux, the ion flux wherein the positively charged ions are the primary curing or processing initiators, having an energy level between 3.6eV and 250eV, and condensing a radiation curable material on the substrate and curing the radiation curable material with the ion flux.

7. A process according to any of claim 6, whereby the substrate is moving at a line speed of at least 50m/min.

8. A process according to any of claims 6 and 7, whereby the condensed radiation curable material has a thickness in the range 0.001µm to 50µm.

9. A process according to any of claims 6 to 8, whereby the unit energy dose to the substrate is no greater than 15 J/cm².

10. A process according to any of claims 6 to 9, whereby the step of generating a plasma comprises providing a plasma gas and exciting the plasma gas to form a gas plasma and optionally providing a further gas that is distinct from the plasma gas.

11. A process according to any of claims 6 to 10, whereby the ion flux is biased from the plasma with a driving voltage that is positive relative to the substrate.

12. A process according to any of claims 6 to 11, whereby the plasma is spatially defined by a magnet array.

13. A process according to any of claims 6 to 12, whereby the dwell time is no greater than 5 minutes.

## Patentansprüche

1. Vorrichtung zur Definition eines Plasmas, wobei die Vorrichtung umfasst:
einen Träger (10), der eingerichtet ist, ein sich bewegendes Substrat (2) zu transportieren;
einen zur Erzeugung eines Plasmas eingerichteten Plasmagenerator (6);
eine Elektrode;
eine Zuführeinrichtung (5), die eingerichtet ist, dem Substrat strahlungshärtbares Material zuzuführen,
wobei die Vorrichtung so eingerichtet ist, dass im Gebrauch das strahlungshärtbare Material auf dem Substrat kondensiert,
**gekennzeichnet durch** eine elektrisch mit der Elektrode verbundene Antriebsspannung, die eingerichtet ist, im Gebrauch positive Ionen innerhalb des Plasmas in Richtung des sich bewegenden Substrats zu lenken, um einen positiven Ionenfluss (6') zu bilden, in dem die positiv geladenen Ionen die primären Aushärtungsinitiatoren sind, wobei der Ionenfluss ein Energieniveau zwischen 3,6eV und 250eV aufweist.

2. Vorrichtung nach einem der vorhergehenden Ansprüche, weiterhin umfassend eine Magnetanordnung (21), die eingerichtet ist, das Plasma räumlich zu begrenzen.

3. Vorrichtung nach einem der vorhergehenden Ansprüche, die so beschaffen ist, dass sie eine Energieeinheitsdosis von nicht mehr als 15 J/cm² liefert.

4. Vorrichtung nach einem der vorhergehenden Ansprüche, wobei der Träger eingerichtet ist, das Substrat mit einer solchen Geschwindigkeit durch den Ionenfluss (6') zu bewegen, dass die Verweilzeit nicht mehr als 5 Minuten beträgt.

5. Vorrichtung nach einem der vorhergehenden Ansprüche, weiterhin umfassend ein Gaszufuhrsystem, das so beschaffen ist, dass es ein Primärgas, aus dem das Plasma erzeugt wird, und ein oder mehrere weitere Gase, die sich von dem Primärgas unterscheiden, zuführt.

6. Verfahren zur Definition eines Plasmas, wobei das Verfahren die folgenden Schritte umfasst:
Bereitstellen eines sich bewegenden Substrats;
Erzeugen eines Plasmas; und
**gekennzeichnet durch** Vorspannen positiver Ionen innerhalb des Plasmas in Richtung des sich bewegenden Substrats, um einen positiven Ionenfluss zu bilden, wobei der Ionenfluss, in dem die positiv geladenen Ionen die primären Aushärtungs- oder Verarbeitungsinitiatoren sind, ein Energieniveau zwischen 3,6eV und 250eV aufweist, und Kondensieren eines strahlungshärtbaren Materials auf dem Substrat und Aushärten des strahlungshärtbaren Materials mit dem Ionenfluss.

7. Verfahren nach einem der Ansprüche 6, wobei sich das Substrat mit einer Liniengeschwindigkeit von mindestens 50m/min bewegt.

8. Verfahren nach einem der Ansprüche 6 und 7, wobei das kondensierte strahlungshärtbare Material eine Dicke im Bereich von 0,001 µm bis 50 µm aufweist.

9. Verfahren nach einem der Ansprüche 6 bis 8, wobei die Energieeinheitsdosis für das Substrat nicht größer als 15 J/cm² ist.

10. Verfahren nach einem der Ansprüche 6 bis 9, wobei der Schritt des Erzeugens eines Plasmas das Bereitstellen eines Plasmagases und das Anregen des Plasmagases zur Bildung eines Gasplasmas und gegebenenfalls die Bereitstellung eines weiteren Gases, das sich von dem Plasmagas unterscheidet, umfasst.

11. Verfahren nach einem der Ansprüche 6 bis 10, wobei der Ionenfluss aus dem Plasma mit einer relativ zum Substrat positiven Antriebsspannung vorgespannt wird.

12. Verfahren nach einem der Ansprüche 6 bis 11, wobei das Plasma durch eine Magnetanordnung räumlich begrenzt wird.

13. Verfahren nach einem der Ansprüche 6 bis 12, wobei die Verweilzeit nicht mehr als 5 Minuten beträgt.

## Revendications

1. Appareil pour former un plasma, l'appareil comprenant :
un support (10) agencé pour transporter un substrat mobile (2) ;
un générateur de plasma (6) agencé pour générer un plasma ;
une électrode ;
un dispositif de distribution (5) agencé pour distribuer un matériau durcissable par rayonnement au substrat, l'appareil étant agencé de sorte que, pendant l'utilisation, le matériau durcissable par rayonnement se condense sur le substrat,
**caractérisé par** une tension de commande reliée électriquement à ladite électrode agencée pour solliciter, pendant l'utilisation, des ions positifs dans le plasma vers le substrat mobile pour former un flux d'ions positifs (6') dans lequel les ions chargés positivement sont des initiateurs de durcissement primaires, dans lequel le flux ionique a un niveau d'énergie situé entre 3,6 eV et 250 eV.

2. Appareil selon une quelconque revendication précédente, comprenant en outre un ensemble d'aimants (21) agencés pour définir spatialement le plasma.

3. Appareil selon une quelconque revendication précédente agencé pour fournir une dose d'énergie unitaire qui n'est pas supérieure à 15 J/cm².

4. Appareil selon une quelconque revendication précédente, dans lequel le support est agencé pour déplacer le substrat à certaine une vitesse à travers le flux ionique (6') de sorte que le temps de séjour n'est pas supérieur à 5 minutes.

5. Appareil selon une quelconque revendication précédente, comprenant en outre un système de distribution de gaz agencé pour distribuer un gaz principal à partir duquel le plasma est généré et un ou plusieurs autres gaz qui sont distincts du gaz principal.

6. Processus de formation d'un plasma, le processus comprenant les étapes consistant à :
fournir un substrat mobile ;
générer un plasma ; et
**caractérisé par** la sollicitation d'ions positifs dans le plasma vers le substrat mobile pour former un flux d'ions positifs, le flux ionique dans lequel les ions chargés positivement sont les initiateurs de durcissement ou de traitement primaires ayant un niveau d'énergie situé entre 3,6 eV et 250 eV, et la condensation d'un matériau durcissable par rayonnement sur le substrat et le durcissement du matériau durcissable par rayonnement dans le flux ionique.

7. Processus selon la revendication 6, dans lequel le substrat est mobile à une vitesse linéaire d'au moins 50 m/min.

8. Processus selon l'une quelconque des revendications 6 et 7, dans lequel le matériau durcissable par rayonnement condensé a une épaisseurdans la plage de 0,001 µm à 50 µm.

9. Processus selon l'une quelconque des revendications 6 à 8, dans lequel la dose d'énergie unitaire pour le substrat n'est pas supérieure à 15 J/cm².

10. Processus selon l'une quelconque des revendications 6 à 9, dans lequel l'étape de génération d'un plasma comprend la fourniture d'un gaz plasma et l'excitation du gaz plasma pour former un plasma gazeux et facultativement la fourniture d'un autre gaz qui est distinct du gaz plasma.

11. Processus selon l'une quelconque des revendications 6 à 10, dans lequel le flux ionique est sollicité à partir du plasma avec une tension de commande qui est positive par rapport au substrat.

12. Processus selon l'une quelconque des revendications 6 à 11, dans lequel le plasma est formé spatialement par un ensemble d'aimants.

13. Processus selon l'une quelconque des revendications 6 à 12, dans lequel le temps de séjour n'est pas supérieur à 5 minutes.
